(19) **Europäisches Patentamt / European Patent Office / Office européen des brevets**

(11) **EP 1 950 235 A1**

(12) **EUROPEAN PATENT APPLICATION**
published in accordance with Art. 158(3) EPC

(43) Date of publication:
**30.07.2008 Bulletin 2008/31**

(21) Application number: **06822395.7**

(22) Date of filing: **26.10.2006**

(51) Int Cl.:
**C08G 18/42** (2006.01)   **C08G 18/75** (2006.01)
**C08K 5/13** (2006.01)   **C08L 75/04** (2006.01)
**G02B 1/04** (2006.01)

(86) International application number:
**PCT/JP2006/321426**

(87) International publication number:
**WO 2007/049722 (03.05.2007 Gazette 2007/18)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **27.10.2005 JP 2005312690**
**21.04.2006 JP 2006117777**
**28.09.2006 JP 2006264586**

(71) Applicant: **Hitachi Chemical Company, Ltd.**
**Tokyo 163-0449 (JP)**

(72) Inventors:
• **TOMIYAMA, Takeo**
**48, Wadai, Tsukuda-shi**
**Ibaraki 300-4247 (JP)**

• **TANAKA, Syouko**
**48, Wadai, Tsukuda-shi**
**Ibaraki 300-4247 (JP)**
• **YOSHIDA, Akihiro**
**48, Wadai, Tsukuda-shi**
**Ibaraki 300-4247 (JP)**
• **KOBAYASHI, Shingo**
**48, Wadai, Tsukuda-shi**
**Ibaraki 300-4247 (JP)**

(74) Representative: **HOFFMANN EITLE**
**Patent- und Rechtsanwälte**
**Arabellastrasse 4**
**81925 München (DE)**

(54) **RESIN COMPOSITION AND OPTICAL MEMBER FORMED FROM THE SAME**

(57)    An object of the present invention is to provide a resin composition giving a cured product which is small in curing shrinkage, high in optical transparency and excellent in optical properties such as resistance against coloration based on light and heat, and which is further excellent in mechanical properties such as breaking strength. In order to achieve the object, the present invention provides a two-pack type resin composition, comprising: a liquid A which is a polyol ingredient containing a polycaprolactone polyol having a functionality of three or more, and a liquid B which is an isocyanate ingredient containing an alicyclic diisocyanate and a hindered phenol antioxidant.

**EP 1 950 235 A1**

## Description

Technical Field

The present invention relates to a resin composition giving a cured product which is high in optical transparency and is excellent in heat resistance, light resistance and mechanical properties; an optical member formed from the cured product and suitable for a transparent substrate, a lens, an adhesive, an optical waveguide, a light emitting diode (LED), a phototransistor, a photodiode, a solid-state image sensor, and other optical semiconductor elements; and a process for producing the same.

Background Art

Hitherto, acrylic resin, which is excellent in transparency and light resistance, has been generally used as a resin for optical members in many cases. In the meantime, the resin for optical members which is used in the field of optical/electronic equipment is required to have heat resistance in a process of mounting on an electronic substrate or the like or in high-temperature operation, or mechanical properties; thus, epoxy resin has been frequently used. In recent years, however, in the optical/electronic equipment field also, the use of a high-intensity laser ray, blue light rays, or near ultraviolet rays has been spreading. Thus, a resin better in transparency, heat resistance and light resistance than conventional resins has been desired.

In general, epoxy resin is high in transparency in the visible range, but does not give a sufficient transparency in ranges from the ultraviolet ray range to the near ultraviolet ray range. A cured product composed of an alicyclic epoxy resin, such as alicyclic bisphenol A diglycidyl ether, and an acid anhydride has a relatively high transparency in the near ultraviolet ray range, but has a problem that the article is easily colored by heat or light, and other problems. For example, Japanese Patent Application Laid-Open No. 2003-171439 and 2004-75894 disclose a method for decreasing an impurity contained in alicyclic bisphenol A diglycidyl ether, which is a cause for the coloration. However, a further improvement in resistance against coloration based on heat and ultraviolet rays is desired. Moreover, the alicyclic epoxy resin is poorer in breaking strength and toughness than aromatic epoxy; thus, an interfacial exfoliation and a crack in a jointed body of the article therefrom and a different species are considered as worrying problems. Another problem is a matter that when the acid anhydride volatilizes when the resin and the anhydride are cured, so that the volume decreases.

Meanwhile, silicone resin has a high transparency up to the near ultraviolet ray range, and the bonding energy of Si-O therein is large. Thus, the resin has a characteristic that the resin has an excellent light resistance and is not easily colored by heat or light. In general, for silicone resin, polymerization is attained by dehydration condensation reaction between silanol groups, condensation reaction between silanol groups and hydrolyzable groups, reaction between methyl silyl groups and vinylsilyl groups by action of an organic peroxide, addition reaction between vinylsilyl groups and hydrosilyl groups, or the like. For example, Japanese Patent Application Laid-Open No. 2004-186168 discloses a silicone resin obtained by addition reaction between vinylsilyl groups and hydrosilyl groups. However, silicone resins obtained by these reactions have problems that the resins may undergo curing blockage when a very small amount of a nitrogen compound, a phosphorus compound, a sulfur compound or the like in the curing atmosphere is blended therewith, and cured products therefrom have a large thermal expansion coefficient, and other problems.

Similarly, acrylic resin is excellent in transparency, and resistance against coloration based on heat and light, but does not have sufficient mechanical properties such as breaking strength. Thus, a further improvement in the properties thereof is desired. There also remains a problem that the curing shrinkage is relatively large so that at the time when the resin is cured, the volume decreases.

Accordingly, a solvent-free resin composition is desired which is in a liquid form at room temperature and gives a cured product which is small in curing shrinkage and is excellent in optical properties such as transparency, light resistance and heat resistance, and mechanical properties such as breaking strength.

An optical semiconductor element (light emitting element) used in an LED or the like is resin-sealed by curing a liquid thermosetting resin solution so as to cover this element. As the method therefor, there is generally used a cast molding method, wherein a resin solution is cast into a mold and then the solution is heated and cured. However, this method has a problem of a poor productivity because of a slow curing of the thermosetting resin solution and further has a problem that voids are incorporated in the cured sealing resin.

Thus, in recent years, desired has been a sealing process making it possible to improve the productivity of optical semiconductor devices. Liquid transfer molding is a molding method of injecting a liquid resin into a high-temperature mold, pressing the resin, and heating/curing the resin. The method is useful since the time for the molding is short so that a high productivity is obtained. The use of this method makes it possible to obtain a molded product having any shape. However, in order to use liquid transfer molding to resin-seal an optical semiconductor element, it is necessary to prepare a transparent resin composition having a curing rate and a viscosity proper for transfer molding.

Disclosure of the Invention

Problems to be solved by the invention

An object of the present invention is to provide a resin composition giving a cured product which is small in curing shrinkage, high in optical transparency and excellent in optical properties such as resistance against coloration based on light and heat, and which is further excellent in mechanical properties such as breaking strength.

Another object of the invention is to provide an optical member high in optical transparency and excellent in light resistance, heat resistance and mechanical properties with a good productivity, using the resin composition. Means for solving the problems

The invention has characteristics described in the following items (1) to (15):

(1) A two-pack type resin composition, comprising: a liquid A which is a polyol ingredient (refer as polyol ingredient liquid A) comprising a polycaprolactone polyol having a functionality of three or more, and a liquid B which is an isocyanate ingredient (refer as isocyanate ingredient liquid B) comprising an alicyclic diisocyanate and a hindered phenol antioxidant.

(2) The resin composition according to the item (1), wherein the polycaprolactone polyol having a functionality of three or more is contained in the polyol ingredient in an amount of 50 to 100% by weight thereof.

(3) The resin composition according to the item (1) or (2), wherein the weight-average molecular weight of the polycaprolactone polyol having a functionality of three or more is 800 or less, and further the hydroxyl group thereof is 200 (KOH·mg/g) or more and the acid value thereof is 2.0 (KOH·mg/g) or more.

(4) The resin composition according to any one of the items (1) to (3), wherein the alicyclic diisocyanate is 4,4'-methylenebis(cyclohexylisocyanate),
isophoronediisocyanate,
1,3-bis(isocyanatomethyl)cyclohexane,
norbornenediisocyanate(2,5-(2,6)bisisocyanatomethyl
[2,2,1]heptane), or a mixture thereof.

(5) The resin composition according to any one of the items (1) to (4), wherein the hindered phenol antioxidant is 3,9-bis[2-{3-(3-tert-butyl-4-hydroxy-5-methylphenyl) propionyl}-1,1-dimethylethyl]-2,4,8,10-tetraoxaspiro [5,5]undecane, or a 3,5-bis(1,1-dimethylethyl)-4-hydroxy, C7-C9 side-chain-alkyl ester of benzenepropionic acid.

(6) The resin composition according to any one of the items (1) to (5), wherein the liquid A is a polyol ingredient liquid $P_A$ which comprises a hydroxyl-group-remaining prepolymer and is obtained by causing a polyol ingredient containing a polycaprolactone polyol having a functionality of three or more and an isocyanate ingredient containing an alicyclic diisocyanate to react with each other so as to set the amount of the hydroxyl groups in the polyol ingredient excessively over that of the isocyanate groups in the isocyanate ingredient.

(7) The resin composition according to any one of the items (1) to (6), wherein the liquid B is an isocyanate ingredient liquid $P_B$ which comprises an isocyanate-group-remaining prepolymer and is obtained by causing a polyol ingredient containing a polycaprolactone polyol having a functionality of three or more and an isocyanate ingredient containing an alicyclic diisocyanate to react with each other so as to set the amount of the isocyanate groups in the isocyanate ingredient excessively over that of the hydroxyl groups in the polyol ingredient.

(8) The resin composition according to the item (6) or (7), wherein the prepolymers in the liquid $P_A$ and the liquid $P_B$ are prepolymers obtained by setting the ratio of the equivalent X of the hydroxyl groups in the polyol ingredient to the equivalent Y of the isocyanate groups in the isocyanate ingredient (X/Y) into the range of 3 to 20 and 0. 05 to 0.3 respectively, and reacting with each other.

(9) The resin composition according to any one of the items (1) to (8), wherein the gelation time at 165°C is from 25 to 120 seconds.

(10) The resin composition according to any one of the items (1) to (9), wherein the viscosity at 25°C is from 10 to 8000 mPa·s.

(11) The resin composition according to any one of the items (1) to (10), wherein the hot time hardness after the composition is heated and cured at 165°C for 2 minutes is a Shore D hardness of 20 or more.

(12) The resin composition according to any one of the items (1) to (11), comprising, as a curing catalyst, an organometallic catalyst containing zirconium or aluminum.

(13) An optical member, obtained by mixing two liquids of a two-pack type resin composition as recited in any one of the items (1) to (12) together so as to set the ratio of the hydroxyl group equivalent thereof to the isocyanate group equivalent thereof into the range of 0.7 to 1.3, and then curing the mixture thermally.

(14) An optical member, molded by subjecting a resin composition as recited in any one of the items (1) to (12) to liquid transfer molding.

(15) An LED wherein a resin composition as recited in any one of the items (1) to (12) is used as a sealing resin for a light emitting element of the LED.

Effects of the invention

The resin composition of the invention gives a cured product which is small in curing shrinkage, high in optical transparency and excellent in optical properties such as resistance against coloration based on light and heat, and which is further excellent in mechanical properties such as breaking strength. For this reason, the composition is suitable as a resin composition for electronic material, such as a sealing resin for optical semiconductors. Moreover, when the resin composition of the invention, which is excellent in heat resistance, light resistance and mechanical strength, is applied to an optical member, the lifespan and the reliability of its optical element are improved. Furthermore, optical semiconductor elements can be resin-sealed with a good productivity since the invention can be applied to liquid transfer molding.

Best Mode for Carrying out the Invention

The resin composition of the invention is a resin composition comprising a polyol ingredient containing a polycaprolactone polyol having a functionality of three or more, and an isocyanate ingredient containing an alicyclic diisocyanate, and is in particular preferably a two-pack type resin composition comprising a liquid A which is a polyol ingredient containing a polycaprolactone polyol having a functionality of three or more, and a liquid B which is an isocyanate ingredient containing an alicyclic diisocyanate and a hindered phenol antioxidant. The "two-pack type resin composition" is a material which is made of at least two compositions, for example, a component A and a component B, and can give a cured product by causing these to react with each other. The method for causing the two-pack resin composition to react homogeneously is a method of adjusting the molecular weights of compounds in the individual components, a method of adding a compatibility accelerator to one or both of the liquids, a method of adding a compound for promoting the reaction or a dispersing agent thereto, or some other method. These methods may be used together. Out of these methods, preferred methods are the method of adjusting the molecular weights, and the method of adding a compatibility accelerator, and particularly preferred method is the method of adjusting the molecular weights since it is convenient.

In general, the reaction cured product of a bifunctional polyether diol and a diisocyanate is a thermoplastic soft cured product, and is poor in heat resistance and humidity resistance. In the case of using, in particular, a polyether diol and diphenylmethane-4,4'-diisocyanate, the product is poor in resistance against coloration based on heat and light. On the other hand, in the cured product of the resin composition of the invention, a three-dimensional crosslinked structure is formed by reaction between the hydroxyl groups of the polycaprolactone polyol and the isocyanate groups of the alicyclic diisocyanate; therefore, the cured product is better in heat resistance, humidity resistance, resistance against coloration based on light, and mechanical properties than the cured product of a polyether diol and an aromatic diisocyanate.

Furthermore, in the case of preparing a solution containing a prepolymer obtained by causing a polyol ingredient comprising a polycaprolactone polyol having a functionality of three or more and an isocyanate ingredient containing an alicyclic diisocyanate to react with each other not to make the ratio between the hydroxyl groups in the polyol ingredient and the isocyanate groups in the isocyanate ingredient into equal amounts, that is, a polyol ingredient liquid $P_A$ containing a hydroxyl-group-remaining prepolymer, or an isocyanate ingredient liquid $P_B$ containing an isocyanate-group-remaining prepolymer, and then using the liquid $P_A$ or liquid $P_B$ to produce a resin cured product, the curing shrinkage is smaller and the compatibility is better than in the case of producing a cured product from monomers of a polyol ingredient and an isocyanate ingredient. For this reason, it is provided an advantage that a time from the mixing to a production of a transparent and homogeneous solution can be made short. Furthermore, the composition can be used in a rapidly-curing process such as liquid transfer molding since the curing speed is larger. In order to use the liquid $P_A$ or the liquid $P_B$ to produce a resin cured product, for example, it is preferred to cause the liquid $P_A$ to react with the liquid B or liquid $P_B$ containing isocyanate groups equal in amount to the remaining hydroxyl groups of the liquid $P_A$, or cause the liquid $P_B$ to react with the liquid A or liquid $P_A$ containing hydroxyl groups equal in amount to the remaining isocyanate groups of the liquid $P_B$, so as to attain the production.

The prepolymer in the liquid $P_A$ is preferably a prepolymer obtained by causing the polyol ingredient and the isocyanate ingredient to react with each other so as to set the ratio of the equivalent X in the hydroxyl groups in the polyol ingredient to the equivalent Y of the isocyanate groups in the isocyanate ingredient (X/Y) into the range of 3 to 20. The prepolymer in the liquid $P_B$ is preferably a prepolymer obtained by causing the polyol ingredient and the isocyanate ingredient to react with each other so as to set the ratio X/Y into the range of 0.05 to 0.3. If the ratio X/Y is less than 3 in the production of the liquid $P_A$, the molecular weight of the prepolymer becomes large so that there is caused a problem that the prepolymer has a high viscosity so as not to be easily handled. If the ratio X/Y is more than 20, the advantageous effects of the prepolymerization are hardly obtained. If the ratio X/Y is more than 0. 3 in the production of the liquid $P_B$, the molecular weight of the prepolymer becomes large so that there is caused a problem that the prepolymer has a high viscosity so as not to be easily handled. If the ratio X/Y is less than 0.05, the advantageous effects of the prepolymerization are hardly obtained. The synthesis of the prepolymer can be made short in time by the addition of a catalyst; however, it is preferred that the reaction is conducted at room temperature or raised temperature in the absence of any catalyst in order to avoid the prepolymer from being colored.

The polyol ingredient in the invention may contain various polyols such as a bifunctional caprolactone diol, a carbonate diol, a polyester diol, a polyether diol, an aliphatic diol, an alicyclic diol, a polyfunctional aliphatic polyol, an acrylic resin polyol. The diols are not particularly limited. Preferably, the diols are each preferably a diol having a weight-average molecular weight of 3,000 or less and an acid value of 2.0 (KOH·mg/g) or less, more preferably a diol having a weight-average molecular weight of 1,000 or less and an acid value of 2.0 (KOH·mg/g) or less. The hydroxyl value of the above-mentioned diols is preferably 50 (KOH·mg/g) or more. Particularly preferred diol is 1,4-butanediol or 1,3-propanediol as a caprolactone diol, carbonate diol, polyester diol, polyether diol or aliphatic diol which has as narrow a molecular weight distribution as possible. Preferred polyfunctional polyol is trimethylolpropane, propane-1,2,3-triol, a derivative thereof to which ethylene oxide or propylene oxide is added, or the like.

The polycaprolactone polyol used in the invention, which has a functionality of three or more, is preferably one having a weight-average molecular weight of 800 or less, a hydroxyl value of 200 (KOH-mg/g) or more, and an acid value of 2.0 (KOH·mg/g) or less, in particular such a liquid polycaprolactone triol. The use of the polycaprolactone polyol, which has a functionality of three or more and has a weight-average molecular weight of 800 or less, a hydroxyl value of 200 (KOH·mg/g) or more, and an acid value of 2. 0 (KOH·mg/g) or less, makes it possible to obtained a cured product which is high in crosslinkage density, hard, and excellent in heat resistance. The molecular weight distribution thereof is preferably as narrow as possible.

The polycaprolactone polyol having a functionality of three or more is contained preferably in an amount of 50 to 100% by weight of all the polyols, more preferably in an amount of 75 to 100% by weight thereof. The other polyol component(s) is/are desirably one or more of the above-mentioned various polyols. When the amount of the polycaprolactone polyol having a functionality of three or more is set into the range of 50 to 100% by weight of all the polyols, it is possible to make the density of the three-dimensional crosslinkage points high to obtained a resin cured product better in heat resistance.

The alicyclic diisocyanate in the invention is preferably a compound having a cyclic skeleton which isocyanate groups are bonded directly or which are bonded with interposed methylene groups. Examples thereof include 1,3-bis(isocyanatomethyl)cyclohexane, norbornenediisocyanate(2,5-(2,6)bisisocyanatomethyl[2,2,1]h eptane), isophoronediisocyanate, 4,4'-methylenebis(cyclohexylisocyanate), isopropylidenebis(4-cyclohexylisocyanate), and cyclohexyldiisocyanate. These may be used alone or in the form of a mixture of two or more thereof. Out of the above, particularly preferred compound are 4,4'-methylenebis(cyclohexylisocyanate), 1,3-bis(isocyanatomethyl)cyclohexane, norbornenediisocyanate(2,5-(2,6)bisisocyanatomethyl [2,2,1]heptane), and isophoronediisocyanate.

As the isocyanate ingredient, for example, the following may be contained besides the alicyclic diisocyanate: an isocyanurate type, biuret type or adduct type polyisocyanate, which is made from hexamethylenediisocyanate as a raw material. Particularly preferred ingredient is an isocyanurate type polyisocyanate, in which hexamethylenediisocyanate is used.

Furthermore, a hindered phenol antioxidant may be contained in the resin composition of the invention. The antioxidant may be contained in any one of the liquids A, B, $P_A$, and $P_B$. From the viewpoint of solubility, it is preferred that the antioxidant is incorporated into the liquid containing the isocyanate ingredient in a large amount. The use of a combination of the hindered phenol antioxidant with a sulfur based antioxidant makes it possible to improve remarkably the light resistance, the heat resistance and mechanical properties of the resin cured product.

Examples of the hindered phenol antioxidant include 3,9-bis[2-{3-(3-tert-butyl-4-hydroxy-5-methylphenyl) propionyl}-1,1-dimethylethyl]-2,4,8,10-tetraoxaspiro[5,5]un decane, or a 3,5-bis(1,1-dimethylethyl)-4-hydroxy, C7-C90 side-chain-alkyl ester of benzenepropionic acid, 4,4'-butylidenebis(6-tert-butyl-3-methylphenol), 2,6-di-tert-butyl-4-methylphenol, and 2,2'-methylenebis(6-tert-butyl-4-methylphenol). Particularly preferred antioxidants are 3,9-bis[2-{3-(3-tert-butyl-4-hydroxy-5-methylphenyl) propionyl}-1,1-dimethylethyl]-2,4,8,10-tetraoxaspiro[5,5]un decane, or a 3,5-bis(1,1-dimethylethyl)-4-hydroxy, C7-C9 side-chain-alkyl ester of benzenepropionic acid.

Examples of the sulfur based antioxidant include tetrakis(3-laurylthiopropionic acid)pentaerythrityl, distearyl-3,3'-thiodipropionic acid, dimyristyl-3,3'-thiodipropionic acid, and dilauryl-3,3'- thiodipropionic acid. In particularly, tetrakis(3-laurylthiopropionic acid)pentaerythrityl is preferable.

The added amount of the antioxidant is preferably from 0.05 to 5% by weight of the whole of the resin composition, in particular preferably from 0. 05 to 0.3% by weight thereof. If the added amount of the antioxidant is less than 0.05% by weight, the advantageous effect of the antioxidant is not observed. On the other hand, if the amount is more than 5% by weight, there are caused a problem about the solubility thereof, a problem of the precipitation thereof when the composition is cured, and other problems.

In general, the reactivity between a hydroxyl group and an acyclic isocyanate group is slower than the reactivity between a hydroxyl group and an aromatic isocyanate. Thus, a curing catalyst is added thereto, whereby the time for the curing can be made short. This catalyst is not particularly limited, and examples thereof include organometallic catalysts of zirconium or aluminum, dibutyltin laurate, a phenol salt of DBU, octylic (or octanoic) acid salts, amines, and imidazole. Particularly preferred curing catalysts are organometallic catalysts such as aluminum sec-butyrate, ethylacetoacetate aluminumdiisopropylate, zirconium tributoxyacetylacetonate, and zirconium tetraacetylacetonate. The added amount of the catalyst is preferably from 0 to 1% by weight of the whole of the resin composition, in particular preferably from 0 to 0.1% by weight thereof. If the added amount of the catalyst is more than 1% by weight, the curing speed becomes too large so that the resin composition is not easily handled. As the added amount is larger, the composition is more easily colored.

Besides the above-mentioned components, the following may be added to the resin composition of the invention: a hindered amine light stabilizer, a phosphorus-based antioxidant, an ultraviolet absorber, an inorganic filler, an organic filler, a coupling agent, a polymerization inhibitor, and others. From the viewpoint of formability or moldability, a releasing agent, a plasticizer, an antistatic agent, a flame retardant and others may be added thereto. These are preferably in a liquid form to keep the light transmissivity of the resin cured product certainly. When these are in a solid form, these are desirably made into particles having particle diameters not more than the wavelength to be used.

About the resin composition of the invention, the gelation time at 165°C is preferably from 25 to 120 seconds. The gelation time in this range makes it possible to attain the resin-sealing of an optical semiconductor element or the production of an optical member by liquid transfer molding. If the gelation time is shorter than 25 seconds, the resin composition solution is cured before the solution flows sufficiently into channels in a mold, so that unfilled regions or voids tend to be generated in the molded product. On the other hand, if the gelation time is more than 120 seconds, the molded product tends to be an insufficiently cured.

About the resin composition of the invention, the viscosity at 25°C is preferably from 10 to 8000 mPa·s, and the lowest viscosity at 165°C is preferably from 3 to 3000 mPa·s. If the viscosity at 25°C is less than 10 mPa·s, the resin solution may leak into a gap of a plunger mobile region in a pot section in a mold. If the viscosity at 25°C is more than 8000 mPa·s, the resin solution is not easily cast into the pot section. If the lowest viscosity at 165°C is less than 3 mPa·s, the air leaking from the gap between upper and lower parts of a mold near channels in the mold is involved into the resin so that voids are easily generated, and other problems are caused. If the viscosity is more than 3000 mPa·s, the resin solution does not flow easily in channels in a mold so that unfilled regions are generated.

About the resin composition of the invention, the hot time hardness after the composition is heated at 165°C for 2 minutes is desirably a Shore D hardness of 20 or more. If this hardness is not 20 or more, at the time of releasing the molded product from the mold, the product does not have a sufficient hardness and may be deformed.

The process for producing the optical member of the invention using the resin composition of the invention is not particularly limited. For example, the following process is preferred: the liquid A and the liquid B, the liquid $P_A$ and the liquid $P_B$, the liquid A and the liquid $P_B$, or the liquid B and the liquid $P_A$ are mixed together so as to make a transparent and homogeneous solution of the resin composition; thereafter, the solution of the resin composition is cast, potted, or poured into a mold, and then the solution is heated and cured, thereby obtaining a cured product. When the resin composition is cured in a short time by liquid transfer molding, preferred composition is a combination of the liquid $P_A$ and the liquid $P_B$, the liquid A and the liquid $P_B$, or the liquid B and the liquid $P_A$, in particular, the liquid $P_A$ and the liquid $P_B$.

The method for stirring these two liquids may be rotation stirring, ultrasonic dispersion or some other method. It is necessary that the resin composition becomes homogenous. A one-pack type resin solutionmaybe prepared by mixing the resins, and then freezing/storing the mixture. In this case, the resin solution may be used by thawing the frozen resin mixture at room temperature before the mixture is cast or potted. Before the resin mixture is cast, potted or poured into a mold, it is desired to subject the resin mixture to vacuum-defoaming in order to remove air bubbles incorporated during the mixing, and carbon dioxide which is generated by reaction between the isocyanate and water in the air.

About the mixing ratio between the liquid A and the liquid B, the liquid $P_A$ and the liquid $P_B$, the liquid A and the liquid $P_B$, or the liquid B and the liquid $P_A$, the liquids are mixed so as to set the ratio of the hydroxyl group equivalent to the isocyanate group equivalent preferably into the range of 0.7 to 1.3, more preferably into the range of 0.8 to 1.1. If this ratio is out of the range of 0.7 to 1.3, the heat resistance, optical properties and mechanical properties of the curedproduct tend to deteriorate.

In the case of curing the composition by casting or potting, heating conditions therefor, which depend on the kinds of the individual components, a combination thereof and the added amounts thereof, are as follows: preferably, heating at 60 to 150°C for about 1 to 10 hours, in particular preferably heating at 80 to 150°C for about 1 to 10 hours. It is desired to raise the curing temperature step by step in order to decrease internal stress generated by a rapid curing reaction.

In the meantime, in the case of using liquid transfer molding to attain the resin-sealing of an optical semiconductor element or the production of an optical member, the attainment can be made by casting the resin composition of the invention into a pot of a molding machine, operating a plunger, transferring the resin composition in the pot into a cavity region made by an upper mold part and a lower mold part, and then heating/curing the resin composition. The mold temperature is desirably a temperature making it possible to shift the resin composition in channels in the mold and further cure the composition in the cavity in a short time. The temperature is preferably from about 120 to 200˚C. The injecting pressure of the resin composition is not particularly limited as long as the pressure is in a range not permitting unfilled portions or voids to be generated in the resin composition in the cavity. The pressure is preferably 2 MPa or more. If the injecting pressure is less than 2 MPa, unfilled portions are easily generated. In order to improve the releasability, a releasing agent may be painted or sprayed onto the side of the mold. Furthermore, in order to restrain the generation of voids, a vacuuming machine may be used. A machine capable of attaining vacuuming is disclosed in, for example, Japanese Patent Application Laid-Open No.2004-160882.

The resin composition of the invention described above is a resin composition giving a cured product which is small in curing shrinkage, high in optical transparency and excellent in heat resistance, light resistance and mechanical properties. The cured product is suitable for a transparent substrate, a lens, an adhesive, an optical waveguide, a light emitting diode (LED), a phototransistor, a photodiode, a solid-state image sensor, and other optical semiconductor elements. Moreover, the use of the resin composition of the inventionmakes it possible to resin-seal an optical semiconductor element with a good productivity by liquid transfer molding, so as to produce optical semiconductor devices such as an LED with a good productivity.

Examples

The invention will be specifically described by way of the following examples.

(Example 1)

As a polyol ingredient, to 48.0 parts by weight of a polycaprolactone triol (A1: PLAKCEL 303, manufactured by Daicel Chemical Industries, Ltd.) having a molecular weight of 300 and a hydroxyl value of 540 (KOH·mg/g), there was added 5.0 parts by weight of a polycaprolactone diol (A4: PLAKCEL 205U, manufactured by Daicel Chemical Industries, Ltd.) having a molecular weight of 530 and a hydroxyl value of 530 (KOH·mg/g), to prepare a homogeneous polyol ingredient liquid A.

Separately, to 46.7 parts by weight of 1,3-bis(isocyanatomethyl)cyclohexane (B1: TAKENATE 600, manufactured by Mitsui Takeda Chemicals Inc.) as an isocyanate, there was added 0.15 part by weight of 3,9-bis[2-{3-(3-tert-butyl-4-hydroxy-5-methylphenyl) propionyl}-1,1-dimethylethyl]-2,4,8,10-tetraoxaspiro [5,5]undecane (C1: SUMIRIZER GA-80, manufactured by Sumitomo Chemical Co., Ltd.) as a hindered phenol antioxidant and 0.15 part by weight of tetrakis(3-laurylthiopropionic acid)pentaerythrityl (D: SUMIRIZER TP-D, manufactured by Sumitomo Chemical Co., Ltd.) as a sulfur based antioxidant, to prepare a homogeneous isocyanate ingredient liquid B.

53 parts by weight of the liquid A and 47 parts by weight of the liquid B were mixed (in the ratio of the hydroxyl group equivalent to the isocyanate group equivalent: 1.0), and then the mixture was stirred at room temperature for 3 hours. Furthermore, the mixture was degassed under a reduced pressure to remove air bubbles. In this way, a resin solution was produced.

Next, the resin solution obtained as described above was poured into molds wherein silicone spacers of 3 mm thickness and 1 mm thickness were each sandwiched between glass plates, to produce cured products. Furthermore, this resin solution was cast into a cavity region in a mold made of polyphthalamide for a surface-mount type LED having an external form size of 3.2 mm x 2.6 mm x 1.8 mm height and a cavity inside diameter of 2.4 mm, and then cured to form a surface-mount type LED package. In the same way, the resin solution was cast into a resin mold for a cannonball-shaped LED having an external form size of 5 mm diameter and 7.5 mm height, and then cured to form a cannonball-shaped LED package. Conditions for the curing in the formation of the two LED packages were as follows: heating at 60˚C for 2 hours, and heating at 80˚C for 4 hours.

(Example 2)

As a polyol ingredient, to 46.5 parts by weight of the (A1), there was added 5.0 parts by weight of the (A4), to prepare a homogeneous polyol ingredient liquid A.

Separately, to 48.2 parts by weight of norbornenediisocyanate(2,5-(2,6)bisisocyanatomethyl[2,2,1]h eptane) (B2: COSMONATE NBDI, manufactured by Mitsui Takeda Chemicals Inc.) as an isocyanate, there was incorporated and dissolved 0.15 part by weight of the (C1) as a hindered phenol antioxidant and 0.15 part by weight of the (D) as a sulfur based antioxidant, to prepare a homogeneous isocyanate ingredient liquid B.

51.5 parts by weight of the liquid A and 48.5 parts by weight of the liquid B were mixed (in the ratio of the hydroxyl group equivalent to the isocyanate group equivalent: 1.0), and then the mixture was stirred at room temperature for 5 hours. Furthermore, the mixture was degassed under a reduced pressure to remove air bubbles. In this way, a resin solution was produced. This resin solution was used to obtain cured products of 3 mm thickness and 1 mm thickness, a surface-mount type LED package and a cannonball-shaped LED package in the same way as in Example 1.

(Example 3)

As polyol ingredients, to 45.4 parts by weight of the (A1) and 4.5 parts by weight of a polycarbonate diol (A5: PLAKCEL CD205PL, manufactured by Daicel Chemical Industries, Ltd.) having a molecular weight of 500 and a hydroxyl value of 230 (KOH·mg/g), there was added 1.9 parts by weight of trimethylolpropane (A6, manufactured by Perstorp), and then the mixture was heated and stirred at 60˚C, to prepare a homogeneous polyol ingredient liquid A.

Separately, to 48.0 parts by weight of the (B1) as an isocyanate ingredient, there was incorporated and dissolved 0.1 part by weight of the (C1) as a hindered phenol antioxidant and 0.1 part by weight of the (D) as a sulfur based antioxidant, to prepare a homogeneous isocyanate ingredient liquid B.

51.8 parts by weight of the liquid A and 48.2 parts by weight of the liquid B were mixed (in the ratio of the hydroxyl group equivalent to the isocyanate group equivalent: 1.0), and then the mixture was stirred at room temperature for 3 hours. Furthermore, the mixture was degassed under a reduced pressure to remove air bubbles. In this way, a resin solution was produced. This resin solution was used to obtain cured products of 3 mm thickness and 1 mm thickness, a surface-mount type LED package and a cannonball-shaped LED package in the same way as in Example 1.

(Example 4)

As a polyol ingredient, to 34.6 parts by weight of the (A1), there was added 6. 9 parts by weight of the (A5), to prepare a homogeneous polyol ingredient liquid A.

Separately, to 28.3 parts by weight of 4,4'-methylenebis(cyclohexylisocyanate) (B3: DESMODULE W, manufactured by Sumitomo Bayer Urethane Co., Ltd.) as an isocyanate ingredient, there was incorporated and dissolved 29.1 parts by weight of an isocyanurate type polyisocyanate (B4: DURANATE THA-100, manufactured by Asahi Kasei Chemicals Corp.), 0.1 part by weight of the (C1) as a hindered phenol antioxidant and 1. 0 part by weight of 3-glycidoxypropylmethyldiethoxysilane (F: KBE-402, manufactured by Shin-Etsu Chemical Co., Ltd.), to prepare a homogeneous isocyanate ingredient liquid B.

41.5 parts by weight of the liquid A and 58.5 parts by weight of the liquid B were mixed (in the ratio of the hydroxyl group equivalent to the isocyanate group equivalent: 1.0), and then the mixture was stirred at room temperature for 5 hours. Furthermore, the mixture was degassed under a reduced pressure to remove air bubbles. In this way, a resin solution was produced. This resin solution was used to obtain cured products of 3 mm thickness and 1 mm thickness, a surface-mount type LED package and a cannonball-shaped LED package in the same way as in Example 1. However, conditions for the curing were as follows: heating at 80˚C for 1 hour, 100˚C for 1 hour, 120˚C for 1 hour, and 150˚C for 1 hour.

(Example 5)

As a polyol ingredient, to 59 parts by weight of a polycaprolactone triol (A2: PLAKCEL 305, manufactured by Daicel Chemical Industries, Ltd.) having a molecular weight of 550 and a hydroxyl value of 300 (KOH·mg/g), there was added 7 parts by weight of the (A4), to prepare a homogeneous polyol ingredient liquid A.

Separately, to 33.7 parts by weight of the (B1) as an isocyanate, there was added 0.15 part by weight of the (C1) as a hindered phenol antioxidant and 0.15 part by weight of the (D) as a sulfur based antioxidant, to prepare a homogeneous isocyanate ingredient liquid B.

66 parts by weight of the liquid A and 34 parts by weight of the liquid B were mixed (in the ratio of the hydroxyl group equivalent to the isocyanate group equivalent: 1.0), and then the mixture was stirred at room temperature for 3 hours. Furthermore, the mixture was degassed under a reduced pressure to remove air bubbles. In this way, a resin solution was produced. This resin solution was used to obtain cured products of 3 mm thickness and 1 mm thickness, and a surface-mount type LED package in the same way as in Example 1.

(Example 6)

To the polyol ingredient liquid A in Example 4, there was added 0.1 part by weight of aluminum sec-butyrate (E: ASBD, manufactured by Kawaken Fine Chemicals Co., Ltd.) as a curing promoter, to prepare a homogeneous polyol ingredient liquid A.

Separately, the same resin solution as in Example 4 was prepared as an isocyanate ingredient liquid B.

41.6 parts by weight of the liquid A and 58.5 parts by weight of the liquid B were mixed (in the ratio of the hydroxyl group equivalent to the isocyanate group equivalent: 1.0), and then the mixture was stirred at room temperature for 5 hours. Thereafter, a liquid transfer molding machine was used to seal a lead frame on which a blue LED element, 0.3 mm x 0.3 mm x 0.3 mm, was mounted so as to mold a surface-mount type LED package. Conditions for the molding were as follows: the mold temperature was 165°C, the injecting pressure was 10 MPa, and the molding time was 90 seconds. In the same way as in Example 1, cured products of 3 mm thickness and 1 mm thickness were formed. For reference, in the liquid transfer molding, a mold having a size equal to that of the mold used in the production of the surface-mount type LED package in Example 1 was used, thereby a resin cured product integrated with the lead frame was formed.

(Example 7)

To 51. 7 parts by weight of the (A1) as a polyol ingredient, there was added 5.2 parts by weight of the (B1) as an isocyanate ingredient (in the ratio of the hydroxyl group equivalent to the isocyanate group equivalent: 9.3), and then the mixture was stirred at room temperature in the atmosphere of nitrogen for 96 hours, to prepare a polyol ingredient liquid $P_A$ containing a hydroxyl-group-remaining prepolymer.

Separately, to 42.9 parts by weight of the (B1) as an isocyanate ingredient, there was incorporated and dissolved 0.1 part by weight of the (C1) as a hindered phenol antioxidant and 0.1 part by weight of the (D) as a sulfur based antioxidant, to prepare a homogeneous isocyanate ingredient liquid B.

56.9 parts by weight of the liquid $P_A$ and 43.1 parts by weight of the liquid B were mixed (in the ratio of the hydroxyl group equivalent to the isocyanate group equivalent: 1.0), so as to produce a surface-mount type LED package and cured products of 3 mm thickness and 1 mm thickness in the same way as in Example 6.

(Example 8)

As a polyol ingredient, to 40.9 parts by weight of the (A1), there was added and dissolved 4.0 parts by weight of the (A5) and 1.6 parts by weight of the (A6) while heating at 60°C, and then 4.8 parts by weight of the (B1) as an isocyanate ingredient was added (in the ratio of the hydroxyl group equivalent to the isocyanate group equivalent: 9.0). Thereafter, the resulting mixture was stirred at room temperature in the atmosphere of nitrogen for 96 hours, to prepare a polyol ingredient liquid $P_A$ containing a hydroxyl-group-remaining prepolymer.

Separately, as a polyol ingredient, to 4.5 parts by weight of the (A1), there was added and dissolved 0.5 part by weight of the (A5) and 0.2 part by weight of the (A6) while heating at 60°C, and then there was added 43.3 parts by weight of the (B1) as an isocyanate ingredient, 0.1 part by weight of the (C1) as a hindered phenol antioxidant and 0.1 part by weight of the (D) as a sulfur based antioxidant (in the ratio of the hydroxyl group equivalent to the isocyanate group equivalent: 0.11). Thereafter, the resulting mixture was stirred at room temperature in the atmosphere of nitrogen for 96 hours, so as to prepare a isocyanate ingredient liquid $P_B$ containing an isocyanate-group-containing prepolymer.

51.3 parts by weight of the liquid $P_A$ and 48.7 parts by weight of the liquid $P_B$ were mixed (in the ratio of the hydroxyl group equivalent to the isocyanate group equivalent: 1.0), to produce a surface-mount type LED package and cured products of 3 mm thickness and 1 mm thickness in the same way as in Example 6.

(Example 9)

As a polyol ingredient, to 31.1 parts by weight of the (A1), there was added 6.2 parts by weight of the (A5), and then was added 2. 9 parts by weight of the (B3) and 2. 8 parts by weight of the (B4) as isocyanate ingredients, and 1.0 part by weight of the (F) as a coupling agent (in the ratio of the hydroxyl group equivalent to the isocyanate group equivalent: 9.0). Thereafter, theresultingmixturewas stirred at room temperature in the atmosphere of nitrogen for 96 hours, to prepare a polyol ingredient liquid $P_A$ containing a hydroxyl-group-remaining prepolymer.

Separately, as a polyol ingredient, to 3. 5 parts by weight of the (A1), there was added 0.7 part by weight of the (A5), and then was added 25.5 parts by weight of the (B3) and 26.2 parts by weight of the (B4) as isocyanate ingredients, and 0.1 part by weight of the (C1) as a hindered phenol antioxidant (in the ratio of the hydroxyl group equivalent to the isocyanate group equivalent: 0.11). Thereafter, the resulting mixture was stirred at room temperature in the atmosphere of nitrogen for 96 hours, to prepare a isocyanate ingredient liquid $P_B$ containing an isocyanate-group-containing prepolymer.

44 parts by weight of the liquid $P_A$ and 56 parts by weight of the liquid $P_B$ were mixed (in the ratio of the hydroxyl group equivalent to the isocyanate group equivalent: 1.0), to produce a surface-mount type LED package and cured products of 3 mm thickness and 1 mm thickness in the same way as in Example 6.

(Example 10)

As a polyol ingredient, to 34.3 parts by weight of the (A1), there was added 3.8 parts by weight of the (A6), and then the mixture was heated and stirred at 60˚C, to prepare a homogeneous solution. Thereafter, to the solution, there was added 1.8 parts by weight of the (B1), 3.0 parts by weight of the (B3) and 0.9 part by weight of an isocyanurate type polyisocyanate (B5: SUMIJOLE N3300, manufactured by Sumitomo Bayer Urethane Co., Ltd.) as isocyanate ingredients, and 1.0 part by weight of the (F) as a coupling agent (the ratio of the hydroxyl group equivalent to the isocyanate group equivalent: 9.0), and then the mixture was stirred at room temperature in the atmosphere of nitrogen for 96 hours, to prepare a polyol ingredient liquid $P_A$ containing a hydroxyl-group-remaining prepolymer.

As a polyol ingredient, to 3. 8 parts by weight of the (A1), there was added 0.4 part by weight of the (A6), and then the mixture was heated and stirred at 60˚C, to prepare a homogeneous solution. Thereafter, to 16.0 parts by weight of the (B1), there was added 27.0 parts by weight of the (B3) and 7.9 parts by weight of the (B5) as isocyanate ingredients, and 0.1 part by weight of a 3,5-bis(1,1-dimethylethyl)-4-hydroxy, C7-C9 side-chain-alkyl ester of benzenepropionic acid (C2: IRGANOX1135, manufactured by Ciba Specialty Chemicals Ltd.) as a hindered phenol antioxidant (in the ratio of the hydroxyl group equivalent to the isocyanate group equivalent: 0.11). The solution was stirred at room temperature in the atmosphere of nitrogen for 96 hours, to prepare a isocyanate ingredient liquid $P_B$ containing an isocyanate-group-containing prepolymer.

44.8 parts by weight of the liquid $P_A$ and 55.2 parts by weight of the liquid $P_B$ were mixed (in the ratio of the hydroxyl group equivalent to the isocyanate group equivalent: 1.0), to produce a surface-mount type LED package and cured products of 3 mm thickness and 1 mm thickness in the same way as in Example 6.

(Comparative example 1)

As a polyol ingredient liquid A, 75.1 parts by weight of a polycaprolactone triol (A3: PLAKCEL 308, manufactured by Daicel Chemical Industries, Ltd.) having a molecular weight of 850 and a hydroxyl value of 190 (KOH·mg/g) as a polyol ingredient were used.

Separately, 24.7 parts by weight of the (B1) as an isocyanate, 0. 1 part by weight of the (C1) as a hindered phenol antioxidant, and 0.1 part by weight of the (D) as a sulfur based antioxidant were mixed with each other, and the solid components were dissolved, to prepare a homogeneous isocyanate ingredient liquid B.

75.1 parts by weight of the liquid A and 24.9 parts by weight of the liquid B were mixed (in the ratio of the hydroxyl group equivalent to the isocyanate group equivalent: 1.0), and then the mixture was stirred at room temperature for 5 hours. Furthermore, the mixture was degassed under a reduced pressure to remove air bubbles. In this way, a resin solution was produced. This resin solution was used to obtain cured products of 3 mm thickness and 1 mm thickness in the same way as in Example 1. However, no transparent cured product was obtained.

(Comparative example 2)

As a polyol ingredient, to 48.1 parts by weight of the (A1), there was added 5.0 parts by weight of the (A4), to prepare a homogeneous polyol ingredient liquid A.

Separately, 46.9 parts by weight of the (B1) as an isocyanate was used as an isocyanate ingredient liquid B.

53.1 parts by weight of the liquid A and 46.9 parts by weight of the liquid B were mixed (in the ratio of the hydroxyl group equivalent to the isocyanate group equivalent: 1.0), and then the mixture was stirred at room temperature for 3 hours. Furthermore, the mixture was degassed under a reduced pressure to remove air bubbles. In this way, a resin solution was produced. This resin solution was used to obtain a surface-mount type LED package and cured products of 3 mm thickness and 1 mm thickness in the same way as in Example 6.

(Comparative example 3)

As a polyol ingredient, to 59.7 parts by weight of the (A1), there was added 6. 9 parts by weight of the (A4), to prepare a homogeneous polyol ingredient liquid A.

Separately, 33.2 parts by weight of 1,3-bis(isocyanatomethyl)benzene (B6: TAKENATE 500, manufactured by Mitsui Takeda Chemicals Inc.) was mixed with 0.1 part by weight of the (C1) as a hindered phenol antioxidant and 0.1 part by weight of the (D) as a sulfur based antioxidant, and the solid components were dissolved, to prepare an homogenerous isocyanate ingredient liquid B.

66.6 parts by weight of the liquid A and 33.4 parts by weight of the liquid B were mixed (in the ratio of the hydroxyl group equivalent to the isocyanate group equivalent: 1.0), and then the mixture was stirred at room temperature for 3 hours. Furthermore, the mixture was degassed under a reduced pressure to remove air bubbles. In this way, a resin solution was produced. This resin solution was used to obtain a surface-mount type LED package and cured products of 3 mm thickness and 1 mm thickness in the same way as in Example 6.

(Comparative Example 4)

To 7.2 parts by weight of the (A1) as a polyol ingredient, there was added 71.9 parts by weight of a hydroxyl-group-containing acrylic resin having a molecular weight of 2000 and a hydroxyl value of 116 (KOH·mg/g) (A7: UH-2032, manufactured by Toagosei Co., Ltd.), to prepare a homogeneous polyol ingredient liquid A.

Separately, 20.9 parts by weight of the (B1) as an isocyanate ingredient was used as an isocyanate ingredient liquid B.

79.1 parts by weight of the liquid A and 20.9 parts by weight of the liquid B were mixed (in the ratio of the hydroxyl group equivalent to the isocyanate group equivalent: 1.0), and then the mixture was stirred at room temperature for 3 hours. Furthermore, the mixture was degassed under a reduced pressure to remove air bubbles. In this way, a resin solution was produced. This resin solution was used to obtain a surface-mount type LED package and cured products of 3 mm thickness and 1 mm thickness in the same way as in Example 6.

The compositions of the liquid A (the liquid $P_A$) and the liquid B (the liquid $P_B$) in the individual working examples and the individual comparative examples are shown in Tables 1 to 3. The blended amounts in the tables are each represented in the unit of part(s) by weight.

[Table 1]

| | | Ex.1 | Ex.2 | Ex.3 | Ex.4 | Ex.5 | Ex.6 |
|---|---|---|---|---|---|---|---|
| Polyol | A1 | 48.0 | 46.5 | 45.4 | 34.6 | - | 34.6 |
| | A2 | - | - | - | - | 59.0 | - |
| | A3 | - | - | - | - | - | - |
| | A4 | 5.0 | 5.0 | - | - | 7.0 | - |
| | A5 | - | - | 4.5 | 6.9 | - | 6.8 |
| | A6 | - | - | 1.9 | - | - | - |
| | A7 | - | - | - | - | - | - |
| Isocyanate | B1 | 46.7 | - | 48.0 | - | 33.7 | - |
| | B2 | - | 48.2 | - | - | - | - |
| | B3 | - | - | - | 28.3 | - | 28.3 |
| | B4 | - | - | - | 29.1 | - | 29.1 |
| | B5 | - | - | - | - | - | - |
| | B6 | - | - | - | - | - | - |
| Hindered phenol based compound | C1 | 0.15 | 0.15 | 0.1 | 0.1 | 0.15 | 0.1 |
| | C2 | - | - | - | - | - | - |
| Sulfur based compound | D | 0.15 | 0.15 | 0.1 | - | 0.15 | - |
| Curing catalyst | E | - | - | - | - | - | 0.1 |
| Coupling agent | F | - | - | - | 1.0 | - | 1.0 |

[Table 2]

| | | Ex.7 | | Ex.8 | | Ex.9 | | Ex.10 | |
|---|---|---|---|---|---|---|---|---|---|
| | | Liq.PA | Liq.B | Liq.PA | Liq.PB | Liq.PA | Liq.PB | Liq.PA | Liq.PB |
| Polyol | A1 | 51. 7 | - | 40.9 | 4.5 | 31. 1 | 3.5 | 34.3 | 3.8 |
| | A2 | - | - | - | - | - | - | - | - |
| | A3 | - | - | - | - | - | - | - | - |
| | A4 | - | - | - | - | - | - | - | - |
| | A5 | - | - | 4.0 | 0.5 | 6. 2 | 0.7 | - | - |
| | A6 | - | - | 1.6 | 0.2 | - | - | 3.8 | 0.4 |
| | A7 | - | - | - | - | - | - | - | - |
| Isocyanate | B1 | 5.2 | 42.9 | 4.8 | 43.3 | - | - | 1.8 | 16.0 |
| | B2 | - | - | - | - | - | - | - | - |
| | B3 | - | - | - | - | 2. 9 | 25. 5 | 3.0 | 27.0 |
| | B4 | - | - | - | - | 2. 8 | 26. 2 | - | - |
| | B5 | - | - | - | - | - | - | 0.9 | 7.9 |
| | B6 | - | - | - | - | - | - | - | - |
| Hindered phenol based compound | C1 | - | 0.1 | - | 0.1 | - | 0.1 | - | - |
| | C2 | - | - | - | - | - | - | - | 0.1 |
| Sulfur based compound | D | - | 0.1 | - | 0.1 | - | - | - | - |
| Curing catalyst | E | - | - | - | - | - | - | - | - |
| Coupling agent | F | - | - | - | - | 1.1 | - | 1.0 | - |

[Table 3]

| | | Com.Ex.1 | Com.Ex.2 | Com.Ex.3 | Com.Ex.4 |
|---|---|---|---|---|---|
| Polyol | A1 | - | 48. 1 | 59.7 | 7. 2 |
| | A2 | - | - | - | - |
| | A3 | 75. 1 | - | - | - |
| | A4 | - | 5.0 | 6. 9 | |
| | A5 | - | - | - | - |
| | A6 | - | - | - | - |
| | A7 | - | - | - | 71.9 |
| Isocyanate | B1 | 24. 7 | 46. 9 | - | 20. 9 |
| | B2 | - | - | - | - |
| | B3 | - | - | - | - |
| | B4 | - | - | - | - |
| | B5 | - | - | - | - |
| | B6 | - | - | 33.2 | - |
| Hindered phenol based compound | C1 | 0. 1 | - | 0. 1 | - |
| | C2 | - | - | - | - |
| Sulfur based compound | D | 0.1 | - | 0. 1 | - |

(continued)

| | | Com.Ex.1 | Com.Ex.2 | Com.Ex.3 | Com.Ex.4 |
|---|---|---|---|---|---|
| Curing catalyst | E | - | - | - | - |
| Coupling agent | F | - | - | - | - |

In the tables, A1 is a polycaprolactone triol having a molecular weight of 300 and a hydroxyl value of 540 (KOH·mg/g); A2 is a polycaprolactone triol having a molecular weight of 550 and a hydroxyl value of 300 (KOH·mg/g) ; A3 is a polycaprolactone triol having a molecular weight of 850 and a hydroxyl value of 190 (KOH-mg/g) ; A4 is a polycaprolactone diol having a molecular weight of 530 and a hydroxyl value of 530 (KOH-mg/g); A5 is a polycarbonate diol having a molecular weight of 500 and a hydroxyl value of 230 (KOH·mg/g); A6 is trimethylolpropane; A7 is a hydroxyl-group-containing acrylic resin having a molecular weight of 2000 and a hydroxyl value of 116 (KOH·mg/g); B1 is 1,3-bis(isocyanatomethyl)cyclohexane; B2 is (2,5-(2,6)bisisocyanatomethyl[2,2,1]heptane; B3 is 4,4'-methylenebis(cyclohexylisocyanate; B4 and B5 are isocyanurate type polyisocyanates; B6 is 1,3-bis(isocyanatomethyl)benzene; C1 is 3,9-bis[2-{3-(3-tert-butyl-4-hydroxy-5-methylphenyl)  propionyl}-1,1-dimethylethyl]-2,4,8,10-tetraoxaspiro[5,5]un  decane; C2 is a 3,5-bis(1,1-dimethylethyl)-4-hydroxy, C7-C9 side-chain-alkyl ester of benzenepropionic acid; D is tetrakis (3-laurylthiopropionic acid)pentaerythrityl; I is dibutyltin laurate; E is aluminum sec-butyrate; and F is 3-glycidoxypropylmethyldiethoxysilane.

<Evaluation>

About the resin cured product obtained in each of the working examples and the comparative examples, the bend elastic constant, the bending strength, the light transmittance, and the Yellowing Index were measured by methods described below. About the resin solution and the resin cured products in each of Examples 6 to 10 and Comparative Examples 3 to 4, besides the physical properties, the gelation time at 165°C, the viscosity at 25°C, and the Shore hardness after the solution was molded were measured by methods described below. About the cannonball-shaped LED package, the surface-mount type LED, and the lead-frame-integrated, surface-mount type LED package produced in each of the working examples and the comparative examples, a temperature cycle test was made by a method described below. About each of the surface-mount type LED packages formed by liquid transfer molding, the liquid transfer moldability was also evaluated. The results are shown in Tables 4, 5 and 6.

(Bend Elastic Constant and Bending Strength)

A test piece, 3 x 20 x 50 mm, was cut out, and a three-point bending test machine (5548 model, manufactured by Instron) was used to make a bending test in the manner of three-point supporting in accordance with JIS-K-6911. The bend elastic constant and the bending strength were calculated out from Equations (1) and (2) described below. The distance between the supporting points was 24 mm, and the crosshead shift speed was 0.5 mm/minute. The measuring temperature was room temperature (25°C).

[Equation 1]

$$Ef = \frac{Lv^3}{4\,W\,h^3}\frac{\Delta P}{\Delta Y} \qquad (1)$$

[Equation 2]

$$\sigma fB = \frac{3\,Lv}{2\,W\,h}P' \qquad (2)$$

In the Equations (1) and (2), Ef: the bending elastic constant (MPa), σfB: the bending strength (MPa), ΔY: the displacement magnitude (mm), ΔP: the load (N), P': the load (N) when the test piece was broken, Lv: the distance between the supporting points, W: the width of the test piece, and h: the thickness of the test piece.

(Light Transmittance and Yellowing Index)

A spectrophotometer (SPECTROPHOTOMETER V-3310, manufactured by Hitachi Ltd.) was used to make a measurement by use of a test piece 1 mm in thickness. The transmittance was measured after the curing (at the initial), and then measured, for the evaluation of resistance against coloration based on heat, after the test piece was allowed to stand still at a high temperature of 150˚C for 72 hours. The measured transmission spectrum was used to obtain three stimulus-values XYZ in the case of a standard light ray C, and then the Yellowing Index (YI), which shows the tone of yellow, was calculated out from the following Equation:

[Equation 3]

$$YI = \left.\frac{100(1.28\,X - 1.06\,Z)}{Y}\right| \qquad (3)$$

(Gelation Time)

The time up to the gelation of the resin solution on a hot plate of 165˚C temperature was measured.

(Viscosity)

An E-type viscometer was used to measure the viscosity of the resin solution at 25˚C.

(Shore Hardness of Molded Product)

A Shore hardness meter with a spring was used to measure the hardness of the resin curded product after the resin solution was molded at 165˚C for 2 minutes.

(Temperature Cycle Test)

Conditions for the test were as follows: a cycle of "a period of 0.5 hour at -40˚C and that of 0.5 hour at 85˚C" was repeated 500 times. After the test, a microscope was used to observe an exfoliation of the resin from the case material, the chips or the like, and a crack in the resin. The number of samples used was 16. When the exfoliation or the crack was observed even in one out of the 16 samples, the resin composition was determined to be bad "×". The resin composition which did not give such a defect was judged to be good "O".

(Liquid Transfer Moldability)

A microscope was used to evaluate an unfilled portion or a void in the external form of the molded product, and a resin burr into the lead frame. The number of samples used was 16. When the unfilled portion, the void or the resin burr, or an excessive deform when the product was taken out from the mold was observed even in one out of the 16 samples, the resin composition was determined to be bad" X ". The resin composition which did not give such a defect was determined to be good "○".
[Table 4]

|  |  | Ex.1 | Ex.2 | Ex.3 | Ex.4 | Ex.5 |
|---|---|---|---|---|---|---|
| Bend elastic constant | MPa | 1800 | 1890 | 1350 | 1410 | 14 |
| Bending strength at room temp. | MPa | > 80 | >88 | > 61 | > 64 | > 1 |
| Initial Transmittance at 400nm Yellowing Index | % | 91 | 91 | 90 | 91 | 91 |
|  | - | 0.7 | 0.6 | 1.0 | 0.8 | 0.5 |

(continued)

|  |  | Ex.1 | Ex.2 | Ex.3 | Ex.4 | Ex.5 |
|---|---|---|---|---|---|---|
| After exposure Transmittance to high temp. at 400nm Yellowing Index | % | 83 | 82 | 87 | 88 | 88 |
|  | - | 3.4 | 2.7 | 1.4 | 1. 6 | 1.3 |
| Temperature cycle test Cannonball-shaped package Surface-mount type package |  |  |  |  |  |  |
|  |  | ○ | ○ | ○ | ○ | - |
|  |  | ○ | ○ | ○ | ○ | ○ |

[Table 5]

| Ex.6 Ex.7 Ex.8 Ex.9 Ex.10 |  |  |  |  |  |  |
|---|---|---|---|---|---|---|
| Bend elastic constant | MPa | 1520 | 1710 | 1420 | 1510 | 1980 |
| Bending strength at room temp. | MPa | >66 | >78 | >64 | >60 | >96 |
| Initial Transmittance at 400nm Yellowing Index | % | 91 | 91 | 91 | 91 | 91 |
|  | - | 0.9 | 0.5 | 0.7 | 0.6 | 0. 5 |
| After exposure Transmittance to high temp. at 400nm | % | 83 | 85 | 83 | 82 | 87 |
| Yellowing Index | - | 3. 4 | 2. 0 | 3.4 | 2. 7 | 2. 1 |
| Temperature cycle test |  |  |  |  |  |  |
| Cannonball-shaped package |  | - | - | - | - | - |
| Surface-mount type package |  | ○ | ○ | ○ | ○ | ○ |
| Gelation time | s | 110 | 80 | 70 | 40 | 6 0 |
| Viscosity | mPa·s | 400 | 3100 | 4200 | 7000 | 5400 |
| Shore D hardness | - | 36 | 35 | 40 | 31 | 23 |
| Liquid transfer moldability | - | ○ | ○ | ○ | ○ | ○ |

[Table 6]

|  |  | Com.Ex.1 | Com.Ex.2 | Com.Ex.3 | Com.Ex.4 |
|---|---|---|---|---|---|
| Bend elastic constant | MPa | - | 1750 | - | - |
| Bending strength at room temp. | MPa | - | >76 | - | - |
| Initial Transmittance at 400nm Yellowing Index | % | - | 91 | - | - |
|  | - | - | 0.5 | - | - |
| After exposure Transmittance to high temp. at 400nm | % | - | 2.6 | - | - |
| Yellowing Index | - | - | 74 | - | - |
| Temperature cycle test |  |  |  |  |  |
| Cannonball-shaped package |  | - | - | - | - |
| Surface-mount type package Gelation time | s | - | - | 23 | 352 |
| Viscosity | mPa·s | - | - | 2050 | 445 |
| Shore D hardness | - | - | - | - | <20 |
| Liquid transfer moldability | - | - | - | x | x |

In Comparative Example 1, no transparent cured product was obtained. In Comparative Example 2, a transparent cured product was obtained, but there was caused a problem that after the product was allowed to stand still at high temperature, the transmittance declined remarkably.

On the other hand, the resin cured products of Examples 1 to 4 had an elastic constant of 1000 MPa or more so as to be hard, and had a high bending trength. Even after they were allowed to stand still at high temperature, a drop in the transmittance thereof was small. About the LED packages produced in Examples 1 to 4, neither exfoliation nor crack was observed in the temperature cycle test so that the packages exhibited excellent temperature cycle characteristic whether their LEDs were cannonball-shaped LEDs or surface-mount type LEDs.

About the resin cured product of Example 5, the bend elastic constant was a very low value of 14 MPa; however, after the product was allowed to stand still at high temperature, a drop in the transmittance was small in the same manner as in Examples 1 to 4. The product exhibited an excellent temperature cycle characteristic about the surface-mount type LED package.

About the resin solutions of Examples 6 to 10, the gelation time was from 30 to 120 seconds, and the viscosity was 8000 mPa·s or less. Thus, the solutions were able to undergo liquid transfer molding. Moreover, the cured products were excellent in elasticity, bending strength and transmissivity. Furthermore, the Shore hardness D was 20 or higher, and no defects such as unfilled portions or voids were present. The surface-mount type LED packages reduced in Examples 6 to 10 exhibited an excellent temperature cycle characteristic.

On the other hand, about the resin solution of Comparative Example 3 and the cured product therefrom, the gelation time was as short as 23 seconds. Thus, when the solution was subjected to transfer molding, many unfilled portions were generated. About the resin solution of Comparative Example 4 and the cured product therefrom, the gelation time was long, and further the Shore hardness was low. Thus, when the solution was subjected to liquid transfer molding, the solution was insufficiently cured. As a result, the resultant was not easily taken out from the mold.

**Claims**

1. A two-pack type resin composition, comprising:

   a liquid A which is a polyol ingredient containing a polycaprolactone polyol having a functionality of three or more; and
   a liquid B which is an isocyanate ingredient containing an alicyclic diisocyanate and a hindered phenol antioxidant.

2. The resin composition according to claim 1, wherein the polycaprolactone polyol having a functionality of three or more is contained in the polyol ingredient in an amount of 50 to 100% by weight thereof.

3. The resin composition according to claim 1 or 2, wherein the weight-average molecular weight of the polycaprolactone polyol having a functionality of three or more is 800 or less, and the hydroxyl group thereof is 200 (KOH·mg/g) or more and the acid value thereof is 2.0 (KOH·mg/g) or less.

4. The resin composition according to any one of claims 1 to 3, wherein the alicyclic diisocyanate is 4,4'-methylenebis (cyclohexylisocyanate), isophoronediisocyanate, 1,3-bis(isocyanatomethyl)cyclohexane, norbornenediisocyanate (2,5-(2,6)bisisocyanatomethyl[2,2,1] heptane), or a mixture thereof.

5. The resin composition according to any one of claims 1 to 4, wherein the hindered phenol antioxidant is 3,9-bis[2-{3-(3-tert-butyl-4-hydroxy-5-methylphenyl) propionyl}-1,1-dimethylethyl]-2,4,8,10-tetraoxaspiro[5,5] undecane, or a 3,5-bis(1,1-dimethylethyl)-4-hydroxy, C7-C9 side-chain-alkyl ester of benzenepropionic acid.

6. The resin composition according to any one of claims 1 to 5, wherein the liquid A is a polyol ingredient liquid $P_A$ which comprises a hydroxyl-group-remaining prepolymer and is obtained by causing a polyol ingredient containing a polycaprolactone polyol having a functionality of three or more and an isocyanate ingredient containing an alicyclic diisocyanate to react with each other so as to set the amount of the hydroxyl groups in the polyol ingredient excessively over that of the isocyanate groups in the isocyanate ingredient.

7. The resin composition according to any one of claims 1 to 6, wherein the liquid B is an isocyanate ingredient liquid $P_B$ which comprises an isocyanate-group-remaining prepolymer and is obtained by causing a polyol ingredient containing a polycaprolactone polyol having a functionality of three or more and an isocyanate ingredient containing an alicyclic diisocyanate to react with each other so as to set the amount of the isocyanate groups in the isocyanate ingredient excessively over that of the hydroxyl groups in the polyol ingredient.

8.  The resin composition according to claim 6 or 7, wherein the prepolymers in the liquid $P_A$ and the liquid $P_B$ are prepolymers obtained by setting the ratio of the equivalent X of the hydroxyl groups in the polyol ingredient to the equivalent Y of the isocyanate groups in the isocyanate ingredient (X/Y) into the range of 3 to 20 and 0.05 to 0.3 respectively, and reacting with each other.

9.  The resin composition according to any one of claims 1 to 8, wherein the gelation time at 165˚C is from 25 to 120 seconds.

10. The resin composition according to any one of claims 1 to 9, wherein the viscosity at 25˚C is from 10 to 8000 mPa·s.

11. The resin composition according to any one of claims 1 to 10, wherein the hot time hardness after the composition is heated and cured at 165˚C for 2 minutes is a Shore D hardness of 20 or more.

12. The resin composition according to any one of claims 1 to 11, comprising, as a curing catalyst, an organometallic catalyst containing zirconium or aluminum.

13. An optical member, obtained by mixing two liquids of a two-pack type resin composition as recited in any one of claims 1 to 12 together so as to set the ratio of the hydroxyl group equivalent thereof to the isocyanate group equivalent thereof into the range of 0.7 to 1.3, and then curing the mixture thermally.

14. An optical member, molded by subjecting a resin composition as recited in any one of claims 1 to 12 to liquid transfer molding.

15. An LED wherein a resin composition as recited in any one of claims 1 to 12 is used as a sealing resin for a light emitting element of the LED.

<table>
<tr><td colspan="2" align="center">**INTERNATIONAL SEARCH REPORT**</td><td colspan="2">International application No.<br>*PCT/JP2006/321426*</td></tr>
</table>

A.   CLASSIFICATION OF SUBJECT MATTER
*C08G18/42(2006.01)i, C08G18/75(2006.01)i, C08K5/13(2006.01)i, C08L75/04 (2006.01)i, G02B1/04(2006.01)i*

According to International Patent Classification (IPC) or to both national classification and IPC

B.   FIELDS SEARCHED

Minimum documentation searched (classification system followed by classification symbols)
C08G18/42, C08G18/75, C08K5/13, C08L75/04, G02B1/04

Documentation searched other than minimum documentation to the extent that such documents are included in the fields searched
Jitsuyo Shinan Koho          1922-1996    Jitsuyo Shinan Toroku Koho    1996-2006
Kokai Jitsuyo Shinan Koho    1971-2006    Toroku Jitsuyo Shinan Koho    1994-2006

Electronic data base consulted during the international search (name of data base and, where practicable, search terms used)

C.   DOCUMENTS CONSIDERED TO BE RELEVANT

| Category* | Citation of document, with indication, where appropriate, of the relevant passages | Relevant to claim No. |
|---|---|---|
| Y | JP 2004-277498 A  (Asahi Kasei Chemicals Corp.), 07 October, 2004 (07.10.04), Claims (Family: none) | 1-15 |
| Y | JP 61-28518 A  (Asahi Chemical Industry Co., Ltd.), 08 February, 1986 (08.02.86), Claims (Family: none) | 1-15 |
| Y | JP 2005-48073 A  (Mitsui Takeda Chemicals, Inc.), 24 February, 2005 (24.02.05), Claims (Family: none) | 1-15 |

☒   Further documents are listed in the continuation of Box C.          ☐     See patent family annex.

| | |
|---|---|
| *    Special categories of cited documents:<br>"A"   document defining the general state of the art which is not considered   to be of particular relevance<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |

| Date of the actual completion of the international search<br>    15 December, 2006 (15.12.06) | Date of mailing of the international search report<br>    26 December, 2006 (26.12.06) |
|---|---|
| Name and mailing address of the ISA/<br>    Japanese Patent Office | Authorized officer |
| Facsimile No. | Telephone No. |

Form PCT/ISA/210 (second sheet) (April 2005)

**INTERNATIONAL SEARCH REPORT**

| International application No. |
| --- |
| PCT/JP2006/321426 |

C (Continuation). DOCUMENTS CONSIDERED TO BE RELEVANT

| Category* | Citation of document, with indication, where appropriate, of the relevant passages | Relevant to claim No. |
| --- | --- | --- |
| Y | JP 2005-47854 A  (Mitsui Takeda Chemicals, Inc.), 24 February, 2005 (24.02.05), Claims (Family: none) | 1-15 |
| Y | JP 53-47453 A  (Asahi Chemical Industry Co., Ltd.), 27 April, 1978 (27.04.78), Claims (Family: none) | 1-15 |
| Y | JP 2001-278941 A  (Mitsui Chemicals, Inc.), 10 October, 2001 (10.10.01), Claims & WO 01/53374 A1          & EP 1167416 A1 & KR 2001110687 A        & CN 1365370 A & US 2003036620 A1        & TW 572925 A | 15 |

Form PCT/ISA/210 (continuation of second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003171439 A
- JP 2004075894 A

- JP 2004186168 A
- JP 2004160882 A